# FASCICULE DE BREVET EUROPEEN

(11) **EP 0 517 112 B1**
(45) Date de publication et mention de la délivrance du brevet: **19.04.1995**
(21) Numéro de dépôt: 92109087.4
(22) Date de dépôt: 29.05.1992
(51) Int. Cl.: C04B 41/88, H01L 39/24, C04B 37/02

(54) **Procédé de réalisation d'un contact électrique pour céramique supraconductrice**
Verfahren zur Herstellung eines elektrischen Kontakts für supraleitende Keramik
Method of making an electrical contact for a super conductive ceramic

(30) Priorité: 04.06.1991 FR 9106417
(43) Date de publication de la demande: 09.12.1992
(73) Titulaire: GEC ALSTHOM SA, 75116 Paris (FR)
(72) Inventeur: Grivon, Fernand, F-91240 Saint Michel sur Orge (FR); Bouthegourd, Jacques, F-95110 Sannois (FR)
(74) Mandataire: Weinmiller, Jürgen

(56) Documents cités:
- EP-A- 0 009 245
- DD-A- 142 480
- DE-A- 3 534 886
- IEEE TRANSACTIONS ON MAGNETICS. vol. 27, no. 2, Mars 1991, NEW YORK US pages1866 - 1869; F. GIVRON ET AL: 'YBaCuO current lead for Helium temperature applications"
- JOURNAL OF APPLIED PHYSICS. vol. 65, no. 4, 15 Février 1989, NEW YORK US pages1792 - 1794; J. D. KATZ ET AL: 'Low-resitivity, YBa2Cu3O7-to-silver electrical contacts by plasma spraying"
- JOURNAL OF THE ELECTROCHEMICAL SOCIETY. vol. 135, no. 5, May 1988, MANCHESTER,NEW HAMPSHIRE US pages 1309 - 1310; Y. TZENG: "Fabrication of electrical contacts to YBa2Cu307x superconductor by molten silver processing"
- SOVIET TECHNICAL PHYSICS LETTERS. vol. 15, no. 5, 1989, NEW YORK US pages 345 -346; V. G. BESSERGENEV ET AL: "Electrical Properties of Ag-YBaCu3O7-x contacts at 20-800 C"
- CHEMICAL ABSTRACTS, vol. 94, no. 57, 1981, Columbus, Ohio, US; abstract no.35356P, TOKYO SHIBAURA ELECTRIC COMPANY "Ceramic boards for electric circuits".

## Description

La présente invention concerne un procédé de réalisation d'un contact électrique pour céramique supraconductrice.

Il s'agit de réaliser un contact électrique de faible résistance entre une amenée de courant, généralement en cuivre, et une céramique supraconductrice à haute température critique, de type RBa₂ Cu₃ O_{y} où R désigne un lanthanide choisi parmi Y, La, Nd, Sm, Eu, Gd, Ho, Er, Tm, Yb, Lu et où y est compris entre 6,9 et 7.

Un tel contact doit permettre le passage de forts courants de l'ordre d'au moins 1000 A, et/ou de fortes densités de courants.

La publication "YBaCuO current lead for liquide helium temperature applications " - par F. Grivon et al. 1990 Applied Superconductivity Conference- Snowmass Colorado, 24-28 sept 90, mentionne le procédé suivant.

On applique à l'aide d'un pinceau sur une pièce en céramique YBaCuO une peinture à base de résine époxy à l'argent; après séchage l'ensemble est soumis à un traitement thermique à haute température sous oxygène suivant le cycle :
- montée en température jusqu'à 800°C à raison de 60°C par heure,
- montée jusqu'à 930°C à raison de 10°C par heure
- palier de 6 heures,
- refroidissement jusqu'à 450°C à raison de 30°C par heure,
- palier de 12 heures à 450°C correspondant à la phase de réoxygénation de ladite céramique.
- refroidissement jusqu'à la température ambiante à raison de 30°C par heure.

Parmi les résultats mentionnés dans la publication précitée la résistance surfacique de contact la plus faible mesurée à 77 K est de 1,7 x 10⁻¹¹Ω.m² avec un courant de 550 Ampères.

La présente invention a pour but de réaliser un contact ayant des performances améliorées pour des courants ou des densités de courant encore plus élevés.

La présente invention a pour objet un procédé de réalisation d'un contact électrique entre une amenée de courant et une pièce en céramique supraconductrice de type RBa₂Cu₃O_{y} où R désigne un lanthanide choisi parmi Y, La, Nd, Sm, Eu, Gd, Ho, Er, Tm, Yb, Lu et où y est compris entre 6,9 et 7, procédé selon lequel on dépose sur ladite pièce une couche en matériau à base de résine contenant de l'argent, on sèche et on effectue sous oxygène un traitement thermique comportant un chauffage à une température supérieure à 900°C et un refroidissement avec un palier à 450°C correspondant à la phase de réoxygénation de ladite céramique, caractérisé par le fait que :
- préalablement au dépôt de ladite couche, on polit la surface de la zone concernée jusqu'à l'obtention d'une rugosité inférieure à 10 »m, et on la dégraisse,
- on dépose ladite couche sur une épaisseur comprise entre 2 et 10 »m en un matériau à base de résine réticulable diluée dans un solvant lourd ne réagissant pas avec les constituants de ladite résine, dans une proportion comprise entre 40 % et 60 % en poids, ledit matériau contenant de l'argent dans une proportion comprise entre 30 % et 45 % en poids du mélange formé par ladite résine et ledit solvant,
- on effectue entre le séchage et ledit traitement thermique la réticulation de ladite résine par passage de ladite pièce dans une étuve vers 100°C pendant environ 1 heure.

Le polissage de ladite zone peut aller jusqu'à l'obtention d'une rugosité de l'ordre de 0,25 »m.

On constate que l'ensemble des conditions opératoires précédentes contribue à la réalisation d'une couche d'argent mince et compacte, bien liée à la céramique par diffusion de grains d'argent dans cette céramique.

Les risques de décollement de la couche sont en effet réduits lorsque l'on diminue la rugosité de la surface de la céramique et lorsque l'on dilue dans un solvant lourd la résine contenant l'argent.

Cette dilution, par exemple dans l'acétate de butyle, le propionate de propyle, ou le butyrate d'éthyle, donne une viscosité moindre au mélange, et permet de réaliser une couche très mince avec une surface réelle de contact optimale entre les grains d'argent et la céramique.

En outre la résine, réticulée lors du passage en étuve vers 100°C pendant au moins 1 heure, favorise l'accrochage des grains d'argent sur la céramique et permet le traitement thermique ultérieur sans désorganiser la couche d'argent. En effet la résine se consume sans passer par une phase liquide ni émettre de bulles gazeuses, et le squelette carboné résultant maintient en place les grains d'argent. Ceci a pour effet d'éviter la fissuration de la couche.

De préférence, lors dudit traitement thermique, ladite pièce est portée à une température comprise entre 940°C et 960°C avec un palier à ladite température de durée au moins égale à 3 heures, ce traitement assurant une diffusion des grains d'argent dans la céramique. Le traitement thermique global est compatible avec les propriétés supraconductrices de la céramique.

D'autres caractéristiques et avantages de la présente invention apparaîtront au cours de la description suivante d'un mode de réalisation donné à titre illustratif mais nullement limitatif.

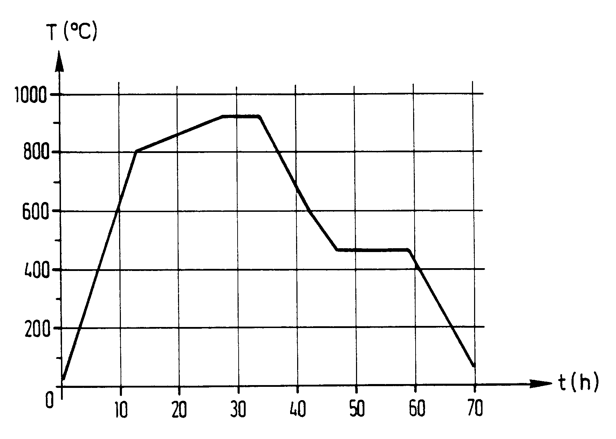

Dans le dessin annexé, la figure unique montre le cycle thermique subi par la pièce selon l'invention après dépôt du contact.

Ladite pièce peut présenter une forme quelconque. Elle peut être analogue à celle qui est décrite dans la publication précitée de F. Grivon et al.

La zone devant recevoir le contact est préparée de la manière suivante. On la polit à l'aide d'un abrasif lui conférant une rugosité de l'ordre du micromètre, puis on dégraisse à l'aide d'un solvant, tel que l'éthanol pur. Avec un pinceau on enduit la zone ainsi traitée d'un matériau ayant la composition suivante (en poids) :

| | |
|---|---|
| - résine réticulable 4929 (Dupont de Nemours) (dont 37,5 parties d'argent et 12,5 parties de produits organiques). | 50 parties |
| - acétate de butyle | 50 parties |

L'épaisseur de la couche ainsi déposée est de l'ordre de 5 micromètres.

Après un court temps de séchage à l'air et à température ambiante, la pièce est portée dans une étuve à 100°C pendant une heure; puis elle subit un traitement thermique sous atmosphère d'oxygène pur, suivant le cycle illustré dans la figure unique annexée (T°C en fonction du temps t en heures).

Les résistances surfaciques mesurées sont les suivantes à 77 K :
. 10⁻¹³ Ω.m² pour une intensité de 10A
. 10⁻¹¹ Ω.m² pour une intensité de 1000A.

Bien entendu l'invention n'est pas limitée au mode de réalisation qui vient d'être décrit. On pourra, sans sortir du cadre de l'invention, remplacer tout moyen par un moyen équivalent ou modifier les durées des différentes phases du cycle thermique mis en oeuvre.

## Revendications

1. Procédé de réalisation d'un contact électrique entre une amenée de courant et une pièce en céramique supraconductrice de type RBa₂Cu₃O_{y} où R désigne un lanthanide choisi parmi Y, La, Nd, Sm, Eu, Gd, Ho, Er, Tm, Yb, Lu et où y est compris entre 6,9 et 7, procédé selon lequel on dépose sur ladite pièce une couche en matériau à base de résine contenant de l'argent, on sèche et on effectue sous oxygène un traitement thermique comportant un chauffage à une température supérieure à 900°C et un refroidissement avec un palier à 450°C correspondant à la phase de réoxygénation de ladite céramique, caractérisé par le fait que :
- préalablement au dépôt de ladite couche, on polit la surface de la zone concernée jusqu'à l'obtention d'une rugosité inférieure à 10 »m, et on la dégraisse,
- on dépose ladite couche sur une épaisseur comprise entre 2 et 10 »m en un matériau à base de résine réticulable diluée dans un solvant lourd ne réagissant pas avec les constituants de ladite résine, dans une proportion comprise entre 40 % et 60 % en poids, ledit matériau contenant de l'argent dans une proportion comprise entre 30 % et 45 % en poids du mélange formé par ladite résine et ledit solvant,
- on effectue entre le séchage et ledit traitement thermique la réticulation de ladite résine par passage de ladite pièce dans une étuve vers 100°C pendant environ 1 heure.

2. Procédé selon la revendication 1 caractérisé par le fait que l'on polit ladite zone jusqu'à l'obtention d'une rugosité de l'ordre de 0,25 »m.

3. Procédé selon l'une des revendications 1 et 2, caractérisé par le fait que, lors dudit traitement thermique, ladite pièce est portée à une température comprise entre 940°C et 960°C avec un palier à ladite température, de durée au moins égale à 3 heures.

4. Procédé selon l'une des revendications précédentes, caractérisé par le fait que ledit solvant lourd est choisi parmi l'acétate de butyle, le proprionate de propyle, le butyrate d'éthyle.

## Claims

1. A method of manufacturing an electrical contact between a current lead and a part made of a superconductive ceramic of the type RBa₂Cu₃O_{y}, where R designates a lanthanide chosen from Y, La, Nd, Sm, Eu, Gd, Ho, Er, Tm, Yb, and Lu, and where Y lies in the range 6.9 to 7, in which method a layer of a material based on a silver-containing resin is deposited on said part, the part is dried, and is then heat treated in oxygen by being heated to a temperature greater than 900°C, and then cooled, with the temperature dwelling at 450°C for a certain length of time corresponding to the phase during which said ceramic is reoxygenated, said method being characterized by the fact that:
prior to depositing said layer, the surface of the relevant region is polished to roughness of less than 10 »m, and any grease is then removed therefrom;
said layer is deposited to a thickness lying in the range 2 »m to 10 »m and is made of a material based on a cross-linkable resin diluted with a heavy solvent in a concentration lying in the range 40% to 60% by weight, which solvent does not react with the ingredients of said resin, said material containing silver in a concentration lying in the range 30% to 45% by weight of the mixture formed by said resin and said solvent; and
between the drying and the heat treatment, said resin is cross-linked by said part being put in an oven at about 100°C for about 1 hour.

2. A method according to claim 1, characterized by the fact that said region is polished until roughness of about 0.25 »m is obtained.

3. A method according to claim 1 or 2, characterized by the fact that, during said heat treatment, said part is heated to a temperature lying in the range 940°C to 960°C, and this temperature is maintained for not less than 3 hours.

4. A method according to any preceding claim, characterized by the fact that said heavy solvent is chosen from butyl acetate, propyl propionate, and ethyl butyrate.

## Patentansprüche

1. Verfahren zur Herstellung eines elektrischen Kontakts zwischen einer Stromzuführung und einem supraleitenden Keramikteil der Art RBa₂Cu₃O_{y}, wobei R ein Lanthanid bezeichnet, das ausgewählt wird aus Y, La, Nd, Sm, Eu, Gd, Ho, Er, Tm, Yb, Lu, und y zwischen 6,9 und 7 liegt, indem man zuerst auf dieses Teil eine Schicht auf der Basis eines Silber enthaltenden Harzes aufbringt und dann trocknet und unter Sauerstoff einer Wärmebehandlung unterwirft, die eine Erwärmung auf eine Temperatur von mehr als 900°C und eine Abkühlung mit einer Haltestufe bei 450°C entsprechend der Rückoxidierung dieser Keramik enthält, dadurch gekennzeichnet, daß
- vor dem Aufbringen der Schicht die Oberfläche der betroffenen Zone poliert wird, bis eine Rauhheit unterhalb von 10 »m erreicht wird, und dann die Zone entfettet wird,
- man die Schicht mit einer Dicke zwischen 2 und 10 »m und aus einem Material aufbringt, das vernetzbares Harz enthält, das in einem schweren Lösungsmittel gelöst ist, welches mit den Komponenten des Harzes nicht reagiert und in einem Anteil von zwischen 40 und 60 Gew.% vorliegt, wobei das Material Silber in einem Anteil von zwischen 30 und 45% Gew.% der von dem Harz und dem Lösungsmittel gebildeten Mischung aufweist,
- zwischen dem Trocknen und der Wärmebehandlung das Vernetzen des Harzes durch Einführen des Teils in einen Trokkenofen bei etwa 100°C während etwa einer Stunde erfolgt.

2. Verfahren nach Anspruch 1, dadurch gekennzeichnet, daß die Zone poliert wird, bis man eine Rauhheit der Größenordnung von 0,25 »m erhält.

3. Verfahren nach einem der Ansprüche 1 und 2, dadurch gekennzeichnet, daß während der Wärmebehandlung das Teil auf eine Temperatur zwischen 940 und 960°C gebracht und auf dieser Temperatur während mindestens drei Stunden gehalten wird.

4. Verfahren nach einem der vorhergehenden Ansprüche, dadurch gekennzeichnet, daß das schwere Lösungsmittel ausgewählt wird aus Butylacetat, Propylproprionat und Äthylbutyrat.
